# FASCICULE DE BREVET EUROPEEN

(11) **EP 3 483 466 B1**
(45) Date de publication et mention de la délivrance du brevet: **05.04.2023**
(21) Numéro de dépôt: 18205529.3
(22) Date de dépôt: 09.11.2018
(51) Int. Cl.: G06Q 10/00

(54) **PROCEDE DE SUIVI ET DE CORRECTION DE LA FABRICATION PAR MOULAGE D'UN COMPOSANT DE FREIN**
VERFAHREN ZUR NACHVERFOLGUNG UND KORREKTUR DER HERSTELLUNG DURCH FORMGUSS EINER BREMSENKOMPONENTE
METHOD FOR MONITORING AND CORRECTING THE MANUFACTURE BY MOULDING OF A BRAKE COMPONENT

(30) Priorité: 09.11.2017 FR 1760545
(43) Date de publication de la demande: 15.05.2019
(73) Titulaire: Hitachi Astemo France, 93700 Drancy (FR)
(72) Inventeur: CHANCELIER, Thierry, 95410 GROSLAY (FR); DUPONT, Janick, 95260 BEAUMONT SUR OISE (FR); SERDIMET, Ludovic, 94360 BRY SUR MARNE (FR)
(74) Mandataire: Brevalex

(56) Documents cités:
- US-A1- 2009 031 550
- US-A1- 2009 032 343

## Description

### DOMAINE TECHNIQUE

La présente invention se rapporte au domaine du contrôle des freins pour automobile et de la maintenance du matériel de fabrication. Les documents US 2009/031550 A1 et US 2009/032343 A1 décrivent une méthode numérique pour modéliser une plaquette de frein.

### ÉTAT DE LA TECHNIQUE ANTÉRIEURE

L'invention concerne plus spécifiquement un procédé de suivi en fabrication de la conformité acoustique d'un composant de frein, tout en permettant d'identifier et corriger les sources de dérives de production à l'origine d'une non-conformité.

Dans l'industrie automobile, les ambiances acoustiques et vibratoires au sein de l'habitacle sont devenues particulièrement soignées en réponse à l'exigence des utilisateurs quant à leur confort.

Au sein du système de freinage, il est courant que certaines vibrations apparaissent, mais celles-ci ne sont généralement pas perceptibles. Un bruit audible accompagne les vibrations lorsqu'elles sont plus importantes dû à un effet d'amplification qui résulte d'une superposition de ou des fréquences propres des composants du frein, ce qui peut donner le sentiment à l'utilisateur que le système de freinage est défectueux et donc que la sécurité du véhicule n'est pas assurée. Bien que l'origine des vibrations soit souvent attribuée aux interactions entre plaquettes et disque de frein, celles-ci peuvent provenir également d'autres composants, tels que l'étrier ou la chape.

Le phénomène de crissement, apparaissant en fin de freinage et dans une gamme de fréquences élevées entre 0kHz et 10kHz, est strident et donc particulièrement désagréable, sans pour autant avoir un impact négatif sur les performances du système de freinage.

Pour limiter ce phénomène de crissement, les équipementiers ont ainsi dimensionné les composants du frein pour que leurs fréquences propres respectives ne coïncident pas, autrement dit ne se superposent pas, dans l'intervalle de fréquences d'apparition du crissement comprises entre 0kHz et 10kHz.

En règle générale, la géométrie d'une pièce a une incidence directe sur les vibrations qu'elle génère. Cependant, toute dérive géométrique de production peut avoir une incidence sur la réponse vibratoire des freins, sans pour autant influencer d'autres paramètres tels que l'état de surface ou l'intégration des composants, rendant l'anomalie indétectable visuellement par un opérateur.

Usuellement, pour faire face à cet inconvénient, certains freins sont prélevés sur la chaîne de production pour subir des essais vibratoires de contrôle qualité visant à vérifier la conformité des fréquences propres qui conditionnent la génération plus ou moins importante du crissement.

Néanmoins, ces essais nécessitent l'utilisation d'une grande quantité de capteurs pour localiser précisément une anomalie géométrique responsable d'une déviation des fréquences exigées. Or, cet important nombre de capteurs engage un temps conséquent d'acquisition et d'interprétation des résultats, ce qui ne permet pas d'identifier rapidement une non-conformité sur une chaîne de fabrication qui continue dans le même temps de produire, souvent à perte, des freins non conformes.

L'invention proposée a donc pour but d'optimiser les essais de contrôle qualité pour rendre plus réactifs le dépistage d'une anomalie et effectuer une intervention rapide pour appliquer un ou plusieurs correctifs au moule.

### EXPOSÉ DE L'INVENTION

A cet effet, l'invention a pour objet un procédé de suivi et de correction de la fabrication par moulage, d'un composant de frein pour véhicule automobile ayant une géométrie de composant et au moins une fréquence propre de composant, avec un moule fabriqué à partir d'un modèle numérique de ce composant ayant une géométrie de référence et au moins une fréquence propre de référence, ce procédé comprenant les étapes de :
- réaliser des simulations à partir du modèle numérique, pour identifier au moins une dimension géométrique pertinente, telle qu'une épaisseur, ayant une incidence sur au moins une fréquence propre, et étant susceptible de subir des variations dues à l'usure du moule ;
- établir une relation de sensibilité liant un écart géométrique, entre la géométrie de référence et la géométrie de composant au niveau de ladite au moins une dimension géométrique pertinente, avec un écart fréquentiel entre ladite au moins une fréquence propre de référence et ladite au moins une fréquence propre de composant ;
- prélever un composant fabriqué par moulage, et mesurer au moins un critère suffisant, selon la relation de sensibilité, pour déterminer l'écart fréquentiel entre ladite au moins une fréquence propre de composant et ladite au moins une fréquence propre de référence ;
- rectifier au moins une portion du moule conditionnant ladite au moins une dimension pertinente des composants qu'il permet de produire si ladite au moins une fréquence propre de composant prélevé est comprise dans une gamme de fréquences d'apparition d'un bruit de freinage prédéterminé.

Avec cette solution, le temps de contrôle de la conformité du composant est réduit, et les défauts du moule à l'origine de cette non-conformité peuvent être identifiés, localisés et corrigés en maintenance de façon préventive.

L'invention concerne également un procédé de suivi et de correction de la fabrication par moulage d'un composant de frein ainsi défini, dans lequel le bruit de freinage prédéterminé est un crissement de fin de freinage.

L'invention concerne également un procédé de suivi et de correction de la fabrication par moulage d'un composant de frein ainsi défini, dans lequel le critère suffisant, représentatif de l'écart fréquentiel entre ladite au moins une fréquence propre du composant prélevé avec ladite au moins une fréquence propre de référence, comporte ladite au moins une dimension géométrique pertinente.

L'invention concerne également un procédé de suivi et de correction de la fabrication par moulage d'un composant de frein ainsi défini, dans lequel la mesure de ladite au moins une dimension pertinente est réalisée avec un scanner tridimensionnel.

L'invention concerne également un procédé de suivi et de correction de la fabrication par moulage d'un composant de frein ainsi défini, dans lequel le critère suffisant, représentatif de l'écart fréquentiel entre ladite au moins une fréquence propre du composant prélevé avec ladite au moins une fréquence propre de référence, comporte ladite au moins une fréquence propre du composant prélevé.

L'invention concerne également un procédé de suivi et de correction de la fabrication par moulage d'un composant de frein ainsi défini, dans lequel la mesure de ladite au moins une fréquence propre est réalisée avec au moins deux capteurs vibratoires.

L'invention concerne également un procédé de suivi et de correction de la fabrication par moulage d'un composant de frein ainsi défini, dans lequel les capteurs vibratoires sont des accéléromètres.

L'invention concerne également un frein comprenant au moins un composant fabriqué avec un moule sur une ligne de production avec le procédé de suivi et de correction de la fabrication par moulage ainsi défini.

L'invention concerne également un procédé de fabrication d'un frein comprenant une étape d'assemblage de différents composants le constituant, dont au moins un de ces composants est fabriqué avant assemblage sur une ligne de production avec le procédé de suivi et de correction de la fabrication par moulage ainsi défini.

### BRÈVE DESCRIPTION DES DESSINS

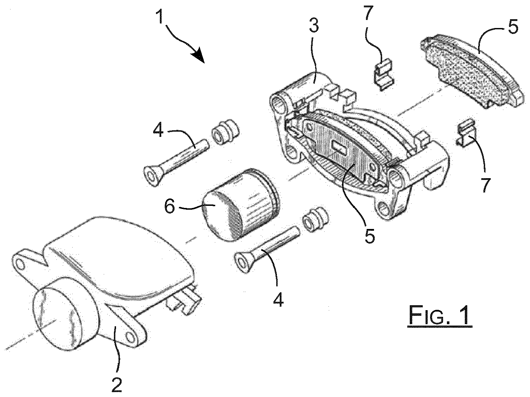

- la figure 1 est une vue éclatée en perspective d'un frein pour véhicule automobile.

### EXPOSÉ DÉTAILLÉ DE MODES DE RÉALISATION PARTICULIERS

### Frein pour véhicule automobile

Un frein, repéré par 1 sur la figure 1, est issu de l'assemblage de composants parmi lesquels on retrouve un étrier 2, une chape 3, des colonnettes 4 de guidage en coulissement de l'étrier, des plaquettes 5 portées par la chape, un actionneur 6 pour presser ces plaquettes 5, et des organes élastiques 7 pour limiter le frottement. Certains de ces composants sont fabriqués par moulage.

### Procédé de fabrication par moulage et conception

Une opération de moulage d'un composant de frein consiste à couler un matériau dans un moule, formé généralement d'un matériau réfractaire, qui porte une empreinte obtenue à partir d'un modèle numérique du composant à fabriquer.

Durant la phase de conception, l'établissement du modèle numérique à l'aide d'un logiciel commence par la détermination d'un volume de base qui respecte un encombrement maximal prévu dans le frein. Ce volume de base est ensuite progressivement affiné pour que le composant respecte différents critères mécaniques et d'intégration.

Le composant doit enfin respecter un critère dynamique vibratoire, à savoir que ses fréquences propres doivent être comprises dans un intervalle prédéfini qui est distinct de celui des autres composants du frein, en particulier lorsque ces fréquences sont dans la gamme entre 0kHz et 10kHz, pour éviter l'effet d'amplification. Il est connu notamment que la géométrie du composant présente une incidence sur ses fréquences propres. En effet, une fréquence propre du composant correspond à une fréquence pour laquelle celui-ci rentre en vibration en se déformant selon un profil particulier et unique, appelé mode propre. Ce profil de vibration est conditionné par la géométrie de ce composant, ou plus précisément par la raideur et la répartition de la masse du composant qui dépendent de sa géométrie.

A cet effet, le modèle est remanié à l'aide du calcul numérique, par éléments finis, pour tendre vers un arrangement géométrique qui optimise la réponse fréquentielle tout en respectant au mieux les précédents critères mécaniques et d'intégration, de manière à aboutir à une définition complète du modèle numérique conforme au cahier des charges.

Un moule associé au modèle est ensuite fabriqué et installé en chaine de production pour débuter la production.

Au fur et à mesure des cycles de moulage et démoulage, la géométrie du composant évolue par rapport à la géométrie de référence du modèle, du fait de l'usure progressive du moule, ce qui peut altérer progressivement la réponse vibratoire du composant.

Dans l'état de la technique, un technicien prélève un composant sur la ligne de production et établit son diagnostic vibratoire selon un protocole nécessitant un nombre important de capteurs, associés à des outils mathématiques et de calcul numérique élaborés. Si le composant ne répond pas au critère dynamique vibratoire, la fabrication est interrompu et le moule est remplacé, ou bien corrigé d'une manière principalement empirique.

L'idée à la base de l'invention est de prévoir un procédé de suivi de fabrication comprenant une étape de contrôle rapide du composant prélevé, pouvant être exécutée par un opérateur de ligne de production ayant à sa disposition soit uniquement des instruments de mesure géométrique, soit un nombre limité de capteurs de vibrations et un ordinateur d'acquisition/visualisation des données.

Autrement dit, l'invention apporte une solution pour recourir à :
- un ensemble de mesures fréquentielles simples du composant, pour directement juger de sa conformité vibratoire et en déduire très simplement la nature et la localisation des défauts dus à l'usure du moule,
- ou inversement un ensemble de mesures dimensionnelles du composant prélevé pour directement caractériser la dérive géométrique due à l'usure du moule, et en déduire très simplement si ce composant répond au critère vibratoire.

### Loi de sensibilité

Il s'agit en premier lieu d'établir une loi analytique simple, dite loi de sensibilité, qui relie entre le composant et son modèle un écart fréquentiel avec un écart dimensionnel. Attendu qu'un tel composant de frein présente une forme généralement complexe, on recourt avantageusement à un technicien de fonderie, capable d'identifier les épaisseurs qui sont les plus susceptibles de varier au cours de l'usure du moule.

Parmi ces épaisseurs, un certain nombre ne présentent pas d'influence significative sur la réponse vibratoire du composant de frein, et peuvent donc être écartées de l'étude. A cette fin, à partir d'une copie conforme du modèle numérique du composant et à l'aide d'un logiciel de simulation, les épaisseurs sont délibérément modifiées individuellement puis en combinaison, en calculant par éléments finis la réponse fréquentielle afin de ne conserver que les épaisseurs pertinentes. Les épaisseurs pertinentes sont celles dont les variations ont une influence déterminante sur la réponse vibratoire du composant telle que calculée par éléments finis.

Il devient dès lors aisé d'établir la loi de sensibilité à partir des résultats obtenus, avec l'écart fréquentiel qui suit une loi polynomiale simple qui est fonction des écarts géométriques de chacune des épaisseurs pertinentes.

### Mise en oeuvre avec des instruments de mesure géométrique

Dans le cadre où l'opérateur, en charge du suivi qualité et de la correction de la fabrication d'un composant de frein, dispose seulement d'instruments de mesure géométrique, le procédé selon l'invention consiste en premier lieu à prélever un composant issu de moulage avec le moule, mesurer les épaisseurs pertinentes et les comparer aux épaisseurs correspondantes de la géométrie de référence.

L'écart fréquentiel est ensuite calculé en injectant les écarts géométriques dans la relation de sensibilité afin de caractériser la conformité vibratoire du composant qui a été prélevé, entendu que la géométrie de référence et la fréquence propre de référence sont connues. Si ce composant n'est pas conforme, autrement dit qu'au moins une des fréquences propres calculées à partir de relation de sensibilité se situe avec une coïncidence en fréquence dans la bande de fréquences 0 à 10kHz, l'opérateur signale l'anomalie et le moule est rectifié au niveau des portions conditionnant les épaisseurs pertinentes.

Le procédé selon l'invention prévoit d'utiliser avantageusement un scanner tridimensionnel pour mesurer l'ensemble des épaisseurs pertinentes. Le scanner tridimensionnel produit une image 3D qui présente l'avantage de pouvoir être superposée sur le modèle numérique à l'échelle 1, renseignant directement des écarts géométriques existant entre le composant et son modèle, pour apprécier rapidement le degré d'usure du moule.

### Améliorations du contrôle à l'aide d'instruments de mesure géométrique

Afin de gagner en réactivité, les étapes consistant à calculer analytiquement les écarts géométriques suivis des écarts de fréquences propres peuvent être supprimée à l'aide de la loi de sensibilité, en établissant des valeurs prédéterminée plafond et plancher pour chacune des épaisseurs pertinentes, correspondant respectivement aux valeurs maximum et minimum pour lesquelles le moule est considéré comme valide. Dès lors, une simple mesure des épaisseurs pertinentes permet de déterminer si le moule doit ou non être rectifié.

### Mise en oeuvre avec des capteurs de vibrations

L'aménagement du procédé de suivi de fabrication avec des capteurs de vibrations, plus particulièrement des accéléromètres, requiert une étape consistant à déterminer une position idéale associée à chaque capteur.

Généralement plus le nombre de capteurs placés sur le composant est élevé, plus les fréquences propres mesurées sont précises. Dans le cadre de l'invention, il est au contraire souhaité de minimiser le nombre de capteurs utilisés pour diminuer le temps du contrôle qualité.

Il devient possible à l'aide d'un logiciel de simulation de soumettre une copie du modèle du composant à un bruit blanc et de localiser les zones permettant de retranscrire le plus fidèlement les fréquences propres du composant. Le nombre de zones retenues est progressivement restreint en répétant l'opération plusieurs fois en changeant délibérément les valeurs d'épaisseurs pertinentes.

Enfin, attendu que les capteurs doivent être positionnés de la même façon pour tout composant prélevé, il s'agit d'écarter les zones associées à, ou situées au proche voisinage, des dimensions géométriques du composant susceptibles de subir des déformations géométriques dû à l'usure du moule. Le procédé selon l'invention prévoit de conserver préférentiellement seulement deux positions idéales.

Dans le cadre de la mise en oeuvre du procédé à l'aide de deux capteurs et d'un ordinateur, l'opérateur prélève un composant, issu de moulage avec le moule fabriqué à partir du modèle numérique de composant, positionne les capteurs et lance l'acquisition des fréquences propres dont la lecture par l'ordinateur suffit à évaluer la conformité.

Si le composant n'est pas conforme en fréquence, l'opérateur signale l'anomalie et le moule est rectifié au niveau des portions conditionnant les épaisseurs pertinentes non admissibles associées, la variation de ces épaisseurs pertinentes étant déterminée en injectant les fréquences propres mesurées dans la loi de sensibilité, entendu que les fréquences propres de références et de la géométrie de référence sont connues.

### Mise en oeuvre combinatoire du procédé avec des instruments de mesure géométrique et des capteurs de vibrations

En outre, le procédé selon l'invention peut également permettre de révéler un défaut de fabrication qui n'est pas lié à l'usure du moule. L'opération consiste à prélever sur la ligne de production un composant et mesurer à la fois ses fréquences propres et ses épaisseurs pertinentes. Si les valeurs d'épaisseurs pertinentes mesurées ne correspondent pas aux valeurs d'épaisseurs calculées analytiquement à partir des fréquences propres mesurées, autrement dit que la loi de sensibilité n'est pas respectée, l'existence d'une source de pollution extérieure à l'usure du moule est mise en exergue.

Des essais complémentaires peuvent alors être effectués pour identifier la source d'erreur, comme par exemple des essais tomographiques permettant d'évaluer la santé matière qui est susceptible d'être la cause de la dispersion dans le cas d'un changement de fournisseur du matériau utilisé pour le moulage.

## Revendications

1. Procédé de suivi et de correction de la fabrication par moulage, d'un composant de frein pour véhicule automobile ayant une géométrie de composant et au moins une fréquence propre de composant, avec un moule fabriqué à partir d'un modèle numérique de ce composant ayant une géométrie de référence et au moins une fréquence propre de référence, ce procédé comprenant les étapes de :
- réaliser des simulations à partir du modèle numérique, pour identifier au moins une dimension géométrique pertinente, telle qu'une épaisseur, ayant une incidence sur au moins une fréquence propre, et étant susceptible de subir des variations dues à l'usure du moule ;
- établir une relation de sensibilité liant un écart géométrique, entre la géométrie de référence et la géométrie de composant au niveau de ladite au moins une dimension géométrique pertinente, avec un écart fréquentiel entre ladite au moins une fréquence propre de référence et ladite au moins une fréquence propre de composant ;
- prélever un composant fabriqué par moulage avec le moule, et mesurer au moins un critère suffisant, selon la relation de sensibilité, pour déterminer l'écart fréquentiel entre ladite au moins une fréquence propre du composant et ladite au moins une fréquence propre de référence ;
- rectifier en maintenance au moins une portion du moule conditionnant ladite au moins une dimension pertinente des composants qu'il permet de produire si ladite au moins une fréquence propre du composant prélevé est comprise dans une gamme de fréquences d'apparition d'un bruit de freinage prédéterminé.

2. Procédé selon la revendication 1 dans lequel le bruit de freinage prédéterminé est un crissement de fin de freinage.

3. Procédé selon la revendication 1 ou 2, dans lequel le critère suffisant, représentatif de l'écart fréquentiel entre ladite au moins une fréquence propre du composant prélevé avec ladite au moins une fréquence propre de référence, comporte ladite au moins une dimension géométrique pertinente.

4. Procédé selon la revendication 3, dans lequel la mesure de ladite au moins une dimension pertinente est réalisée avec un scanner tridimensionnel.

5. Procédé selon la revendication 1 ou 2, dans lequel le critère suffisant, représentatif de l'écart fréquentiel entre ladite au moins une fréquence propre du composant prélevé avec ladite au moins une fréquence propre de référence, comporte ladite au moins une fréquence propre du composant prélevé.

6. Procédé selon la revendication 5, dans lequel la mesure de ladite au moins une fréquence propre est réalisée avec au moins deux capteurs vibratoires.

7. Procédé selon la revendication 6, dans lequel les capteurs vibratoires sont des accéléromètres.

8. Frein pour véhicule automobile (1) comprenant au moins un composant fabriqué avec un moule sur une ligne de production avec le procédé de suivi et de correction selon l'une des revendications précédentes.

9. Procédé de fabrication d'un frein pour véhicule automobile (1) comprenant une étape d'assemblage de différents composants le constituant, dont au moins un de ces composants est fabriqué avant assemblage sur une ligne de production avec le procédé de suivi et de correction selon l'une des revendications 1 à 7.

## Patentansprüche

1. Verfahren zur Nachverfolgung und Korrektur der Herstellung durch Formguss einer Bremsenkomponente für ein Kraftfahrzeug, die eine Komponentengeometrie und mindestens eine Komponenteneigenfrequenz aufweist, mit einer Gussform, die anhand eines digitalen Modells dieser Komponente, das eine Referenzgeometrie und mindestens eine Referenzeigenfrequenz aufweist, gefertigt wurde, wobei dieses Verfahren die folgenden Schritte beinhaltet:
- Durchführen von Simulationen anhand des digitalen Modells, um mindestens ein relevantes geometrisches Maß, wie etwa eine Dicke, zu identifizieren, das sich auf mindestens eine Eigenfrequenz auswirkt und durch den Verschleiß der Gussform variieren kann;
- Erstellen einer Empfindlichkeitsrelation, die eine geometrische Abweichung zwischen der Referenzgeometrie und der Komponentengeometrie im Bereich des mindestens einen relevanten geometrischen Maßes mit einer Frequenzabweichung zwischen der mindestens einen Referenzeigenfrequenz und der mindestens einen Komponenteneigenfrequenz in Beziehung setzt;
- Entnehmen einer durch Formguss mit der Gussform hergestellten Komponente und Messen mindestens eines hinreichenden Kriteriums gemäß der Empfindlichkeitsrelation, um die Frequenzabweichung zwischen der mindestens einen Eigenfrequenz der Komponente und der mindestens einen Referenzeigenfrequenz zu bestimmen;
- Nacharbeiten mindestens eines Abschnitts der Gussform, der das mindestens eine relevante Maß der Komponenten, die mit der Gussform produziert werden können, bedingt, wenn die mindestens eine Eigenfrequenz der entnommenen Komponente in einem Frequenzbereich liegt, in dem ein vorbestimmtes Bremsgeräusch auftritt.

2. Verfahren nach Anspruch 1, wobei das vorbestimmte Bremsgeräusch ein Quietschen am Ende des Bremsvorgangs ist.

3. Verfahren nach Anspruch 1 oder 2, wobei das hinreichende Kriterium, das für die Frequenzabweichung zwischen der mindestens einen Eigenfrequenz der entnommenen Komponente und der mindestens einen Referenzeigenfrequenz repräsentativ ist, das mindestens eine relevante geometrische Maß umfasst.

4. Verfahren nach Anspruch 3, wobei das Messen des mindestens einen relevanten Maßes mit einem dreidimensionalen Scanner durchgeführt wird.

5. Verfahren nach Anspruch 1 oder 2, wobei das hinreichende Kriterium, das für die Frequenzabweichung zwischen der mindestens einen Eigenfrequenz der entnommenen Komponente und der mindestens einen Referenzeigenfrequenz repräsentativ ist, die mindestens eine Eigenfrequenz der entnommenen Komponente umfasst.

6. Verfahren nach Anspruch 5, wobei das Messen der mindestens einen Eigenfrequenz mit mindestens zwei Vibrationssensoren durchgeführt wird.

7. Verfahren nach Anspruch 6, wobei die Vibrationssensoren Beschleunigungsmesser sind.

8. Bremse für ein Kraftfahrzeug (1), die mindestens eine Komponente beinhaltet, die mit einer Gussform auf einer Produktionslinie mit dem Verfahren zur Nachverfolgung und Korrektur nach einem der vorhergehenden Ansprüche hergestellt wird.

9. Verfahren zur Herstellung einer Bremse für ein Kraftfahrzeug (1), das einen Schritt des Zusammenbauens unterschiedlicher Komponenten, die diese bilden, beinhaltet, wobei mindestens eine dieser Komponenten vor dem Zusammenbau auf einer Produktionslinie mit dem Verfahren zur Nachverfolgung und Korrektur nach einem der Ansprüche 1 bis 7 hergestellt wird.

## Claims

1. A method for monitoring and correcting the manufacture by moulding of a brake component for an automobile vehicle having a component geometry and at least one component eigen frequency, with a mould manufactured from a digital model of this component having a reference geometry and at least one reference eigen frequency, this method comprising the steps of:
- performing simulations from the digital model, to identify at least one relevant geometric dimension, such as a thickness, having an incidence at least on the eigen frequency and being likely to undergo variations due to wear of the mould;
- establishing a sensitivity relationship relating a geometric deviation, between the reference geometry and the component geometry at said at least one relevant geometric dimension, with a frequency deviation between said at least one reference eigen frequency and said at least one component eigen frequency;
- sampling a component manufactured by moulding with the mould, and measuring at least one criterion sufficient, according to the sensitivity relation, to determine the frequency deviation between said at least one eigen frequency of the component and said at least one reference eigen frequency;
- grinding in maintenance at least one portion of the mould conditioning said at least one relevant dimension of the components it allows to be produced if said at least one eigen frequency of the component sampled is included in a frequency range of occurrence of a predetermined braking noise.

2. The method according to claim 1, wherein the predetermined braking noise is an end-of-braking squeal.

3. The method according to claim 1 or 2, wherein the sufficient criterion, representative of the frequency deviation between said at least one eigen frequency of the component sampled with said at least one reference eigen frequency, includes said at least one relevant geometric dimension.

4. The method according to claim 3, wherein measuring said at least one relevant dimension is performed with a three-dimensional scanner.

5. The method according to claim 1 or 2, wherein the sufficient criterion, representative of the frequency deviation between said at least one eigen frequency of the component sampled with said at least one reference eigen frequency, includes said at least one eigen frequency of the component sampled.

6. The method according to claim 5, wherein measuring said at least one eigen frequency is performed with at least two vibratory sensors.

7. The method according to claim 6, wherein the vibratory sensors are accelerometers.

8. A brake for an automobile vehicle (1) comprising at least one component manufactured with a mould on a production line with the monitoring and correction method according to one of the preceding claims.

9. A method for manufacturing a brake for an automobile vehicle (1) comprising a step of assembling different components making it up, at least one of these components being manufactured before assembly on a production line with the monitoring and correction method according to one of claims 1 to 7.
